# EUROPÄISCHE PATENTSCHRIFT

(11) **EP 0 516 579 B1**
(45) Veröffentlichungstag und Bekanntmachung des Hinweises auf die Patenterteilung: **22.06.1994**
(21) Anmeldenummer: 92810261.5
(22) Anmeldetag: 06.04.1992
(51) Int. Cl.: B23K 1/19, H01G 1/153

(54) **Durchkontaktierung eines Isolierstoffteils**
Interface connection through an insulating part
Contact à travers une pièce isolante

(30) Priorität: 26.05.1991 EP 91108553
(43) Veröffentlichungstag der Anmeldung: 02.12.1992
(73) Patentinhaber: ENDRESS + HAUSER GMBH + CO., D-79689 Maulburg (DE)
(72) Erfinder: Hegner, Frank, Dr., W-7850 Lörrach (DE); Klähn, Thomas, Dipl.-Ing., W-7800 Freiburg/Br (DE)
(74) Vertreter: Morstadt, Volker, Dipl.-Ing. c/o Endress + Hauser Flowtec AG

(56) Entgegenhaltungen:
- WO-A-90/11610
- CH-A- 225 448
- DE-C- 946 074
- GB-A- 1 587 253

## Beschreibung

Die Erfindung betrifft eine Durchkontaktierung einer Bohrung eines hochtemperaturbeständigen und vakuumtauglichen Isolierstoffteils, eine Verwendung dieser Durchkontaktierung bei einem Drucksensor und ein Verfahren zu deren Herstellung.

In der eigenen WO-A 90/11610, ist eine Durchkontaktierung einer Bohrung in einem Isolierstoffteil (dort als elektrische Durchführung bezeichnet) beschrieben, die aus einem in die Bohrung eingesetzten und darin verlöteten, mit Aktivhartlot umhüllten Anschlußleiter besteht, dessen Kern einen thermischen Ausdehnungskoeffizienten hat, der kleiner als der des Isolierstoffteils ist.

Die Dichtheit der Durchkontaktierung wird insb. bei Keramik, Glas oder Einkristallen als Isolierstoffteil wesentlich dadurch bestimmt, daß nach dem Abkühlen des Aktivhartlots das Isolierstoffteil nicht durch unzulässig große Zugkräfte beansprucht werden darf, da diese das Materialgefüge zerreißen und somit die Verbindung zwischen Isolierstoffteil und Anschlußleiter an dieser Stelle undicht machen würden.

Da es bei der vorbeschriebenen Anordnung zwar für den Anschlußleiterkern eine gewisse Auswahl an Materialien mit kleinerem thermischen Ausdehnungskoeffizienten als der des Isolierstoffteils gibt, der thermische Ausdehnungskoeffizient von Aktivhartloten jedoch nur schwierig ebenfalls kleiner als der des Isolierstoffteils gemacht werden kann, müssen die Stärke der Aktivhartlot-Umhüllung und der Durchmesser des Anschlußleiterkerns bzw. das Durchmesserverhältnis Anschlußleiterkern/Anschlußleiter in Abhängigkeit vom Durchmesser der Bohrung bei sehr beengter Parameterwahl sorgfältig aufeinander abgestimmt werden; u.U. muß eine so geringe Stärke der Aktivhartlot-Umhüllung realisiert werden, daß der mit Aktivhartlot umhüllte Anschlußleiter selbst nur noch unter Schwierigkeiten und mit hohen Kosten hergestellt werden kann.

Weiterer, allerdings zum Teil schon weit zurückliegender Stand der Technik gibt nur die allgemeinen Hinweise, entsprechend der DE-C 946 074 das Isolierstoffteil vor dem Löten mit eingebrannten Metallflächen zu versehen - was aber ja gerade vermieden werden soll - oder nach Auftragen von Metall auf das Isolierstoffteil dieses mittels eines Lotes mit dem Anschlußleiter zu verlöten bzw. nach der GB-A 15 87 253 ein keramisches Röhrchen in ein Rohr größeren Durchmessers aus rostfreiem Stahl mittels eines Titanrings hart einzulöten. Dieser bildet nach dem Löten einen Lötwulst, ohne daß das Titan in den Spalt zwischen den beiden Rohren eingedrungen wäre. Bei dem Kondensator nach der CH-A 225 448 liegt ein ähnlicher Lötwulst vor, dessen Material ebenfalls nicht in den Spalt zwischen Anschlußleiter und Isolierstoffteil eingedrungen ist.

Zur bezweckten Vakuumdichtheit und wegen der Vermeidung von Rißbildungen in der erkalteten Lötstelle ist es aber unbedingt erforderlich, daß gerade die Spaltinnenflächen vom Aktivhartlot verlötet werden. Es muß also dorthin gelangen, was nur durch Kapillarkräfte geschehen kann. Diesen wirkt aber die Oberflächenspannung entgegen.

Da ferner wegen zu vermeidender Sprödigkeit der Lötstelle der Anteil an Aktivmetall - das ist mindestens ein reaktives Element wie Titan, Zirkonium, Beryllium, Hafnium oder Tantal - in der Aktivhartlot-Legierung nur so groß gemacht werden kann, daß das Isolierstoffteil gerade ausreichend benetzt wird, erschien den Erfindern der vom geschilderten Stand der Technik gezeigte Weg nicht gangbar, da er nicht zur Benetzung des Spaltes führen mußte.

Ausgehend von der oben erläuterten Problematik der aktivhartlotumhüllten Anschlußleiter ist es somit eine Aufgabe der Erfindung, die zur Auswahl stehenden Materialien (Isolierstoff; Metalle mit kleinerem thermischen Ausdehnungskoeffizienten als das Isolierstoffteil; Aktivhartlote) anders und neuartig so anzuwenden, daß auf die Umhüllung des Anschlußleiterkerns mit Aktivhartlot verzichtet werden kann.

Zur Lösung dieser Aufgabe und der geschilderten Gesamtproblematik besteht die Erfindung nach Anspruch 1 in einer Durchkontaktierung einer Bohrung eines hochtemperaturbeständigen und vakuumtauglichen Isolierstoffteils, insb. aus Keramik, aus Glas oder aus einem Einkristall, welche Durchkontaktierung aus einem in die Bohrung eingesetzten metallischen Anschlußleiter besteht, dessen thermischer Ausdehnungskoeffizient kleiner als der des Isolierstoffteils ist und dessen mindestens eines Ende, wenn es mit mindestens einer Oberfläche des Isolierstoffteils fluchtet, mittels Aktivhartlot überdeckt ist, das ihn mit dem Isolierstoffteil hochvakuumdicht verlötet, oder, wenn das Ende aus mindestens einer Oberfläche hervorsteht, ringförmig mittels Aktivhartlot mit dem Isolierstoffteil hochvakuumdicht verlötet ist.

Die Erfindung besteht nach Anspruch 5 ferner in einer Verwendung dieser Durchkontaktierung bei einem Drucksensor mit einer Membran und einen Grundkörper, die gegenseitig beabstandete, ebene, zur Bildung mindestens eines Kondensators mit mindestens einer Leitschicht oder zur Bildung mindestens eines Dehnmeßstreifens mit mindestens einer Widerstandsschicht versehene Innenflächen aufweisen, die mittels einer mit dieser Innenfläche fluchtenden Durchkontaktierung zur jeweiligen Rückseite hin durchkontaktiert sind.

Die Erfindung besteht nach Anspruch 6 schließlich in einem Verfahren zum Herstellen einer Dwchkontaktierung einer Bohrung eines hochtemperaturbeständigen und vakuumtauglichen Isolierstoffteils, insb. aus Keramik, aus Glas oder aus einem Einkristall, welche Durchkontaktierung aus einem in die Bohrung eingesetzten metallischen Anschlußleiter besteht, dessen thermischer Ausdehnungskoeffizient kleiner als der des Isolierstoffteils ist und dessen mindestens eines Ende, wenn es mit mindestens einer Oberfläche des Isolierstoffteils fluchtet, mittels Aktivhartlot überdeckt ist, das ihn mit dem Isolierstoffteil hochvakuumdicht verlötet, oder, wenn das Ende aus mindestens einer Oberfläche des Isolierstoffteils hervorsteht, ringförmig mittels Aktivhartlot mit dem Isolierstoffteil hochvakuumdicht verlötet ist, mit mindestens einer auf mindestens einer der Oberflächen des Isolierstoffteils verlaufenden und den Anschlußleiter kontaktierenden Leitschicht, mit folgenden Merkmalen: Derartiges Aufbringen der Leitschicht auf das mit der an der Leitschichtseite eine Ansenkung aufweisenden Bohrung versehene Isolierstoffteil, daß die Leitschicht in die Bohrung hineinreicht;
Einschieben des Anschlußleiters in die Bohrung;
derartiges Aufweiten des an der Leitschichtseite liegenden Endes des Anschlußleiters, daß dieses und die in die Bohrung hineinreichende Leitschicht kaltverschweißt werden;
Aufbringen einer ausreichenden Menge einer Aktivhartlotpaste und Erhitzen in Vakuum oder in einer Gasatmosphäre auf eine Temperatur oberhalb der Schmelztemperatur des Aktivhartlots bis zu dessen vollständigem Aufschmelzen sowie darauffolgendes Abkühlenlassen.

Für die Erfinder war es äußerst überraschend, daß es mit zur Benetzung der Berührungstelle mit dem Aktivhartlot gerade ausreichendem aktivmetallanteil trotzdem gelingt, ein Eindringen des Aktivhartlots in den Spalt zwischen dem Anschlußleiter und dem Isolierstoffteil bei gleichzeitiger Benetzung beider Teile und damit die gewünschte Vakuumdichtheit zu erreichen. Die Benetzung erfolgt über die gesamte Eindringtiefe und -fläche des in den Spalt hineingezogenenen Aktivhartlots, was bedeutet, daß es dort nicht an Aktivmetall verarmt und dadurch unbenetzt im Spalt läge.

Nach einer Ausgestaltung der Erfindung hat der Anschlußleiter einen Durchmesser, der für kleinere Durchmesser der Bohrung (2) als 1 mm ca. 2% bis 15% kleiner als der Durchmesser der Bohrung ist.

Nach einer anderen Ausgestaltung der Erfindung hat das Isolierstoffteil eine auf mindestens einer seiner Oberflächen verlaufende und den Anschlußleiter kontaktierende Leitschicht. Dabei kann bevorzugt die Leitschicht aus Tantal und der Anschlußleiter aus Tantal, Molybdän, Wolfram oder einer Eisen-Nickel-Legierung bestehen, die gegebenenfalls noch Kobalt enthält.

Bei einer Ausgestaltung des Verfahrens der Erfindung wird die Leitschicht bevorzugt aufgesputtert.

Bei einer anderen Ausgestaltung des Verfahrens der Erfindung hat das Vakuum einen Restgasdruck von weniger als 0,01 »bar (= 1 mPa).

Bei einer weiteren Ausgestaltung des Verfahrens der Erfindung hat die Gasatmosphäre einen Druck von höchstens 10 mbar (= 1 kPa) und/oder die Gasatmosphäre besteht aus einem inerten Gas oder einem Reaktivgas oder aus einem Gemisch von inerten und/oder reaktiven Gasen.

Die Erfindung wird nun anhand der Figuren der Zeichnung näher erläutert, in der gleiche Teile mit denselben Bezugszeichen versehen sind.
- Fig. 1: zeigt schematisch im Schnitt als Ausführungsbeispiel eine erste Variante einer Durchkontaktierung,
- Fig. 2: zeigt schematisch im Schnitt als Ausführungsbeispiel eine zweite Variante einer Durchkontaktierung,
- Fig. 3: zeigt schematisch im Schnitt als Ausführungsbeispiel eine Durchkontaktierung mit gleichzeitiger Anwendung der beiden Varianten,
- Fig. 4: zeigt schematisch im Schnitt das Ausführungsbeispiel einer Weiterbildung der ersten Variante einer Durchkontaktierung,
- Fig. 5: zeigt schematisch im Schnitt das Ausführungsbeispiel einer Weiterbildung der zweiten Variante einer Durchkontaktierung,
- Fig. 6: zeigt den Grundriß eines kapazitiven Drucksensors mit Durchkontaktierungen, und
- Fig. 7: zeigt schematisch eine Schnittansicht des Drucksensors der Fig. 6 entlang der Schnittlinie A-B.

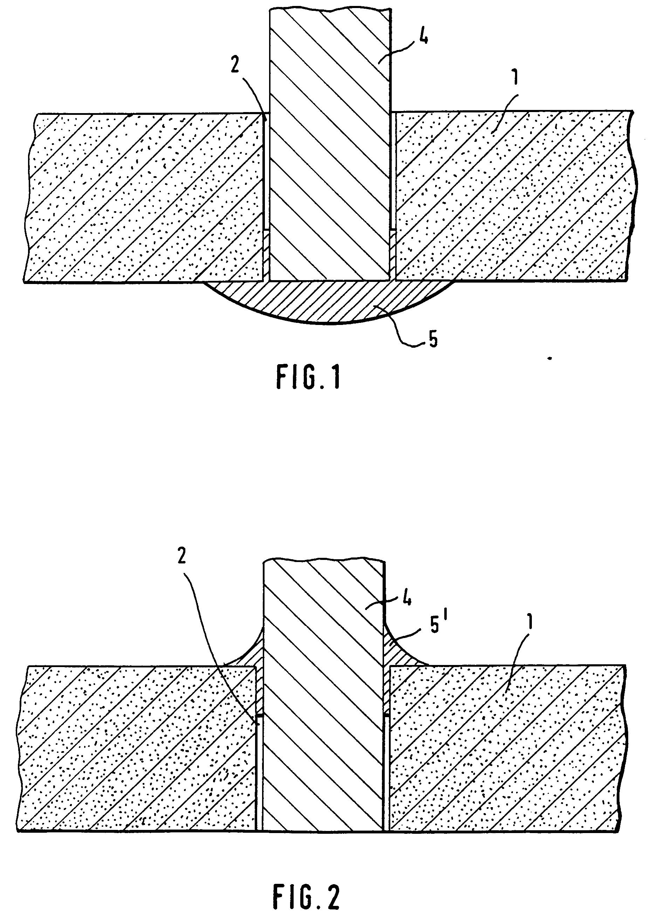

Die Fig. 1 zeigt schematisch im Schnitt und stark vergrößert als Ausführungsbeispiel die erste Variante einer Durchkontaktierung nach der Erfindung. Ein hochtemperaturbeständiges und vakuumtaugliches Isolierstoffteil 1 ist mit einer Bohrung 2 eines geeigneten Durchmessers versehen. In der Bohrung 2 sitzt ein Anschlußleiter 4, der in der Figur an der Unterseite des Isolierstoffteils 1 mit dieser fluchtend endet und an der Oberseite über diese hervorsteht. Das fluchtende Ende des Anschlußleiters 4 ist mit einer ausreichenden Menge Aktivhartlot 5 überdeckt und dadurch mit dem Isolierstoffteil 1 verlötet. Durch Kapillarwirkung, die die Oberflächenspannung überwiegt, wandert das Aktivhartlot in seiner flüssigen Phase in die Bohrung 2 hinein, so daß sich nach dem Erkalten eine hochvakuumdichte Verbindungsstelle ergibt, die außerden temperaturwechsel- und -schockresistent ist.

Die Fig. 2 zeigt schematisch im Schnitt und stark vergrößert als Ausführungsbeispiel die zweite Variante einer Dwchkontaktierung nach der Erfindung. Ein hochtemperaturbeständiges und vakuumtaugliches Isolierstoffteil 1 ist wieder mit einer Bohrung 2 eines geeigneten Durchmessers versehen. In der Bohrung 2 sitzt ein Anschlußleiter 4, der in der Figur an der Unterseite des Isolierstoffteils 1 mit dieser fluchtend endet und an der Oberseite über diese hervorsteht. An dieser Stelle ist der Anschlußleiter 4 ringförmig mit einer ausreichenden Menge Aktivhartlot 5′ umgeben und dadurch mit dem Isolierstoffteil 1 hochvakuumdicht verlötet. Durch Kapillarwirkung, die die Oberflächenspannung überwiegt, wandert auch bei dieser Variante das Aktivhartlot in seiner flüssigen Phase in die Bohrung 2 hinein, so daß sich nach dem Erkalten wiederum eine hochvakuumdichte Verbindungsstelle ergibt, die temperaturwechsel- und -schockresistent ist.

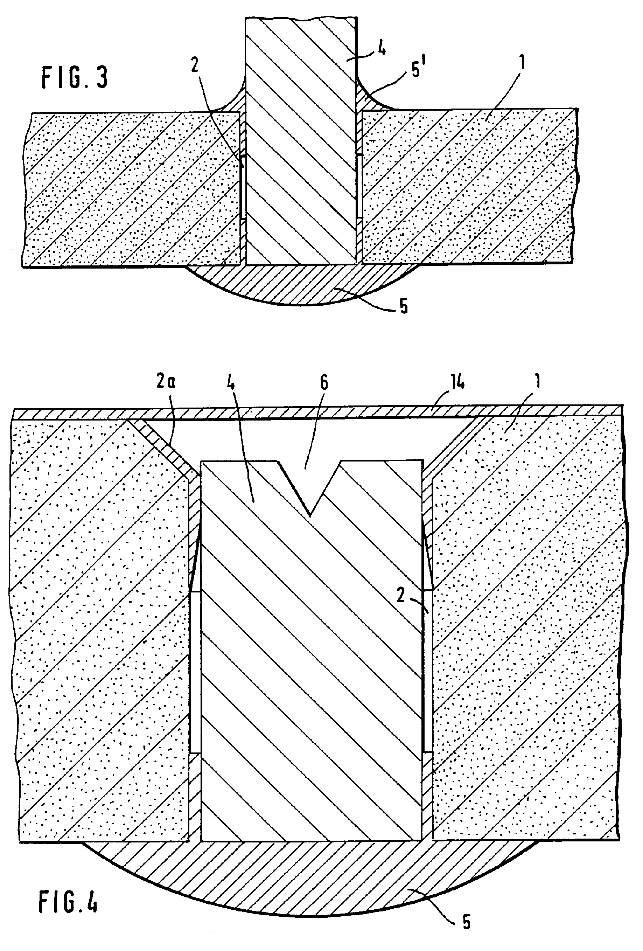

Die Fig. 3 zeigt die gemeinsame Anwendung der oben erläuterten beiden Varianten an der Ober- bzw. an der Unterseite eines Isolierstoffteils 1. Damit ergibt sich eine besonders feste und in obigem Sinne widerstandsfähige Verbindung, da sowohl an der Unter- als auch an der Oberseite durch Kapillarwirkung Aktivhartlot in den schmalen Spalt zwischen der Wand der Bohrung 2 und dem Anschlußleiter 4 eindringt.

Bei einer in Fig. 4 im Schnitt stark vergrößert gezeigten Weiterbildung der Erfindung hat die Bohrung 2 an ihrem einen Ende eine Ansenkung 2a. Auf der die Ansehung aufweisenden Fläche befindet sich eine Leitschicht 14, die sich auch in die Bohrung hinein erstreckt und dort, langsam dünner werdend, endet. In der Bohrung 2 sitzt wieder ein Anschlußleiter 4. Durch eine Einkerbung 6 ist angedeutet, daß der Anschlußleiter 4 im Bereich der Ansenkung 2a derart aufgeweitet ist, daß die in die Bohrung hineinreichende Leitschicht 14 mit dem Anschlußleiter 4 ringsum kaltverschweißt ist. Die Aufweitung kann z.B. mittels eines körnerartigen Stempels, über auch z.B. durch einfaches Stauchen mittels eines stumpfen Stempels erreicht werden.

Mit der von der die Leitbahn 14 tragenden Fläche abgewandten Fläche des Isolierstoffteils 1 fluchtet das andere Ende des Anschlußleiters 4, das wieder mit Aktivhartlot 5 bedeckt und mit dem Isolierstoffteil 1 an dieser Fläche und durch Kapillarwirkung auch in der Bohrung 2 verlötet ist.

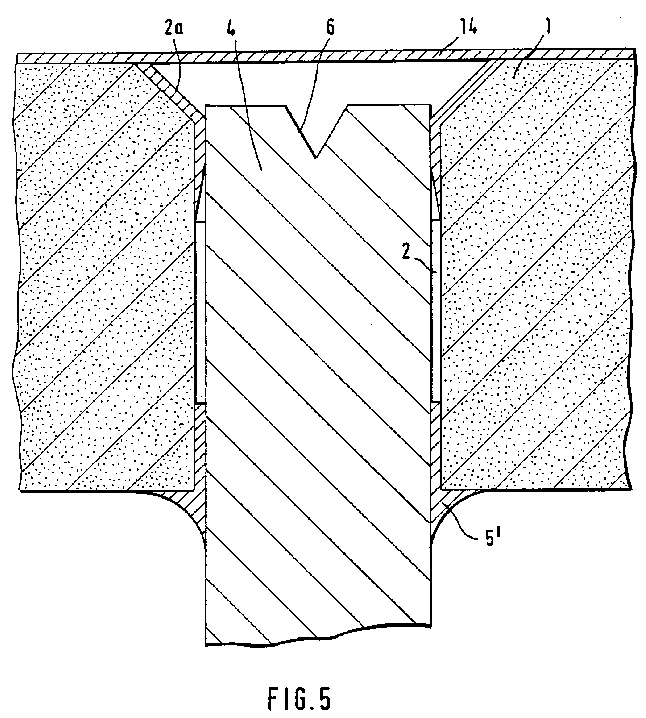

Bei einer in Fig. 5 im Schnitt stark vergrößert gezeigten Weiterbildung der Erfindung ist die Ausbildung an der Oberseite des Isolierstoffteils 1 identisch mit der von Fig. 4. Jedoch steht der Anschlußleiter 4 an der Unterseite des Isolierstoffteils 1 hervor und ist daher ringförmig mittels des Aktivhartlots 5′ mit dem Isolierstoffteil 1 durch Kapillarwirkung auch in der Bohrung 2 verlötet.

Die Durchkontaktierung nach der Erfindung wird bei der Weiterbildung nach den Fig. 4 und 5 wie folgt hergestellt: Die mit der erforderlichen oder gewünschten Anzahl von Bohrungen und Ansenkungen vorgefertigten Isolierstoffteile werden auf der Ansenkungsseite mit Leitschichten derart versehen, z.B. durch Sputtern oder Aufdampfen, daß das Leitschichtmetall auch in die Bohrungen hineinreicht, also deren Mantelfläche von Mündungsteil der Bohrung aus einwärts ebenfalls metallisiert wird. Dann werden Anschlußleiter in die Bo gen eingeschoben oder bei der Massenfertigung, z.B. durch Rütteln eines Magazins, in dem die Isolierstoffteile gehaltert sind, eingefüllt - jedenfalls sind Bohrungsdurchmesser und Anschluffleiterdurchmesser so aufeinander abgestimmt, daß die Anschlußleiter ohne nennenswerten Kraftaufwand in die Bo gen eingebracht werden können.

Anschließend wird das an der Leitschichtseite liegende Ende der Anschlußleiter derart aufgeweitet, daß die in die jeweilige Bohrung hineinreichende Leitschicht mit dem jeweiligen Anschlußleiter ringsum kaltverschweißt wird - das Aufweiten wird z.B. mit einem geeigneten Preßwerkzeug oder auf andere Weise vorgenommen. Danach werden auf die Enden der Anschlußleiter, die in der nichtangesenkten Fläche fluchtend münden, für die Bildung der jeweiligen Aktivhartlotverbindung ausreichende Mengen einer Aktivhartlotpaste mit gewünschter Zusammensetzung aufgebracht, die aufgrund ihrer Pasteneigenschaft dort haften. Oder es werden um die Enden der Anschlußleiter, die über die nichtangesenkte Fläche hervorstehen, ringförmige Aktivhartlotpaste-Wülste gelegt.

Schließlich werden die so konfektionierten Isolierstoffteile in Vakuum oder geeigneter Gasatmosphäre auf eine Temperatur oberhalb der Schmelztemperatur der Aktivhartlotpaste bzw. -Wülste bis zu deren vollständigem Aufschmelzen erhitzt, worauf abkühlen gelassen wird.

Die Aktivhartlotpaste kann je nach Anwendungsfall durch Drucken hinsichtlich Menge und Schichtdicke gut reproduzierbar oder durch Dispensen in gut bemeßbaren Mengen aufgebracht werden. Außerdem können aufgrund der Hafteigenschaften der Aktivhartlotpaste die zu verlötenden Teile exakt positioniert und fixiert werden.

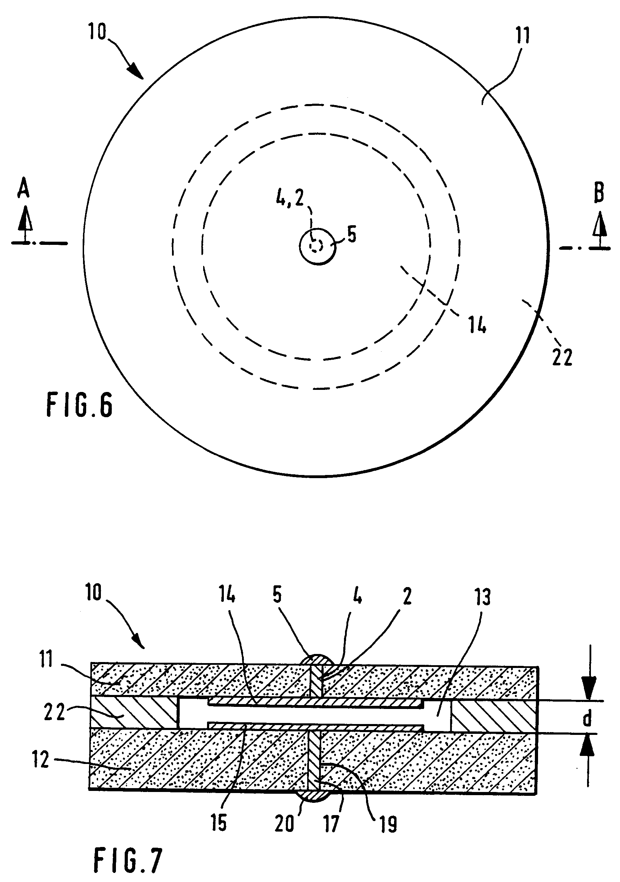

Die Durchkontaktierung nach der Erfindung kann besonders vorteilhaft bei einem kapazitiven oder bei einem resistiven Drucksensor angewendet werden. Der Aufbau eines derartigen kapazitiven Drucksensors 10 ist in den Fig. 6 und 7 schematisch gezeigt. Der Drucksensor 10 hat eine Membran 11 in Form einer kreisrunden Scheibe mit planparallelen Flächen, die rings um den Umfang mit einem kreisrunden Grundkörper 12 in einem definierten Abstand d, z.B mittels eines Aktivhartlot-Formteils, zusammengefügt ist. Dadurch wird zwischen der oberseite des Grundkörpers 12 und der gegenüberliegenden fläche der Membran 11 eine Kammer 13 gebildet, die an ihrem Umfang hochvakuumdicht verschlossen ist. Membran 11 und Grundkörper 12 sind Isolierstoffteile, insb. Keramikteile. Die Membran ist elastisch und verformt sich unter einer auf sie einwirkenden Kraft oder einem Druck. An den einander zugewandten Flächen von Membran und Grundkörper sind innerhalb der Kammer 13 kreisförmige Leitschichten 14, 15 aus geeignetem Metall angebracht, z.B. aufgesputtert oder aufgedampft. Mit der Leitschicht 14 ist der Anschlußleiter 4 und mit der Leitschicht 15 der Anschlußleiter 17, wie anhand der Fig. 1 erläutert, verbunden, wobei letzterer in einer Bohrung 19 des Grundkörpers 12 mittels Aktivhartlot 20 befestigt ist.

Die beiden Leitschichten 14, 15 bilden die Elektroden eines Kondensators, dessen Kapazität vom Abstand zwischen den Leitschichten abhängt. Wenn sich die Membran 11 unter der Einwirkung einer Kraft oder eines Druckes verformt, ändert sich dieser bestand und damit auch die Kapazität des Druckensors. Diese kann mittels einer an die Anschlußleiter 4, 17 angeschlossenen elektronischen Schaltung gemessen werden. Durch Abteilung der Leitschichten in innere und äußere, davon beabstandete Kreisringflächen können auch mehr als nur ein Kondensator realisiert werden.

Bei einem resistiven Drucksensor ist anstatt der metallischen Leitschicht 14 mindestens eine Widerstandsschicht vorhanden, die mittels entsprechender Durchkontaktierungen elektrisch kontaktiert sind, während die Leitschicht 15 entfällt.

Als Material für das Isolierstoffteil 1 einen sich besonders gut Keramik, Glas oder Einkristalle, z.B. Saphir. Im falle von Keramik ist bevorzugt an Aluminiumoxid-Keramik, insb. an solche mit einer Reinheit von 96%, gedacht, wie sie bei den geschilderten Drucksensoren angewendet wird. Als Material für den Anschlußleiter 4 und/oder 17 einen sich Metalle wie Tantal, Molybdän, Wolfram, Rhenium, Osmium oder Eisen-Nickel-Legierungen, die zusätzlich noch Kobalt enthalten können, wie die letzteren unter den Handelsbezeichnungen Kovar oder Vacon käuflich sind. Diese Metalle haben alle, insb. ihm Vergleich mit der erwähnten Aluminiumoxid-Keramik, einen kleineren thermischen Ausdehnungskoeffizienten als der der Aluminiumoxid-Keramik, der 7 ppm/K beträgt.

Als Material für die Leitschichten 14, 15 ist besonders Tantal geeignet, wie in der eigenen älteren EP-A-445382 (Stand der Technik gemäß Art. 54(3) EPÜ), für die erwähnten kapazitiven Drucksensoren beschrieben ist.

Als Material für das Aktivhartlot 5, 5′, 20 sind Silber-, Silber/Kupfer- oder Silber/Kupfer/Indium-Legierungen geeignet, denen mindestens ein reaktives Element wie Titan, Zirkonium, Beryllium, Hafnium oder Tantal zulegiert ist. Das Aktivhartlot bzw. die Aktivhartlotpaste besteht also z.B. aus einer Silber/ Titan-, einer Silber/Kupfer/Titan- oder einer Silber/Kupfer/ Indium/Titan-Legierung.

Wie bereits oben erwähnt wurde, hat nach einer Ausgestaltung der Erfindung der Anschlußleiter 4, 17 einen Durchmesser, der für kleinere Durchmesser der Bohrung 2 als 1 mm ca. 2% bis 15% kleiner als der Durchmesser der Bohrung ist. Beispielsweise ist bei einem Anschlußleiter aus Tantal sein Durchmesser höchstens 10% kleiner als die Bohrung 2 in einem Isolierstoffteil 1 aus Zirkoniumoxid bzw. höchstens 5% kleiner als die Bohrung 2 in einem Isolierstoffteil 1 aus Aluminiumoxid bzw. höchstens 3% kleiner als die Bohrung 2 in einem Isolierstoffteil 1 aus Siliciumkarbid.

Bei einem Keramik-Grundkörper mit einen Durchmesser der Bohrung 2 von etwa 0,65 mm und einer Weite des Spaltes zwischen Anschlußleiter 4 und Isolierstoffteil 1 von 20 »m beträgt die Eindringtiefe des Aktivhartlots etwa 2 mm.

## Patentansprüche

1. Durchkontaktierung einer Bohrung (2) eines hochtemperaturbeständigen und vakuumtauglichen Isolierstoffteils (1), insb. aus Keramik , aus Glas oder aus einem Einkristall, welche Durchkontaktierung aus einem in die Bohrung (2) eingesetzten metallischen Anschlußleiter (1) besteht, dessen thermischer Ausdehnungskoeffizient kleiner als der des Isolierstoffteils (1) ist und dessen mindestens eines Ende, wenn es mit mindestens einer Oberfläche des Isotierstoffteils fluchtet, mittels Aktivhartlot (5) überdeckt ist, das ihn mit dem Isolierstoffteil hochvakuumdicht vertötet, oder, wenn das Ende aus mindestens einer Oberfläche hervorsteht, ringförmig mittels Aktivhartlot (5′) mit dem Isolierstoffteil hochvakuumdicht verlötet ist.

2. Durchkontaktierung nach Anspruch 1 mit einem Anschlußleiter (4), dessen Durchmesser für kleinere Durchmesser der Bohrung (2) als 1 mm ca. 2% bis 15% kleiner als der Durchmesser der Bohrung ist.

3. Durchkontaktierung nach Anspruch 1 oder 2 mit mindestens einer auf mindestens einer der Oberflächen des Isolierstoffteils (1) verlaufenden und den Anschlußleiter (4) kontaktierenden Leitscnicht (14, 15).

4. Durchkontaktierung nach Anspruch 3, bei dem die Leitschicht (14, 15) aus Tantal und der Anschlußleiter aus Tantal, Molybdän, Wolfram oder einer Eisen-Nickel-Legierung besteht, die gegebenenfalls noch Kobalt enthält.

5. Verwendung einer Durchkontaktierung nach eimem der Ansprüche 1 bis 4 bei einem Drucksensor (10) mit einer Membran (11) und einem Grundkörper (12), die gegenseitig beabstandete, ebene, zur Bildung mindestens eines Kondensators mit mindestens einer Leitscnicht (14, 15) oder zur Bildung mindestens eines Dehnmeßstreifens mit mindestens einer Widerstandsschicht versehene Innenflächen aufweisen, die mittels einer mit dieser Innenfläche fluchtenden Durchkontaktierung zur jeweiligen Rückseite hin durchkontaktiert sind.

6. Verfahren zum Herstellen einer Durchkontaktierung einer Bohrung (2) eines hochtemperaturbeständigen und vakuumtauglichen Isollerstoffteils (1), insb. aus Keramik, aus Glas oder aus einem Einkristall, welche Durchkontaktierung aus einem in die Bohrung (2) eingesetzten metallischen Anschlußleiter (4) besteht, dessen thermischer Ausdehnungskoeffizient kleiner als der des Isolierstoffteils (1) ist und dessen mindestens eines Ende, wenn es mit mindestens einer Oberfläche des Isolierstoffteils fluchtet, mittels Aktivhartlot (5) überdeckt ist, das ihn mit dem Isolierstoffteil hochvakuumdicht verlötet, oder, wenn das Ende aus mindestens einer Oberfläche des Isolierstoffteils nervorsteht, ringförmig mittels Aktivhartlot (5′) mit dem Isolierstoffteil hochvakuumdicht verlötet ist, mit mindestens einer auf mindestens einer der Oberflächen des Isolierstoffteils (1) verlaufenden und den Ansclußleiter (4) kontaktierenden Leitschicht (14, 15), mit folgenden Merkmalen:
- Derartiges Aufbringen der Leitschicht (14, 15) auf das mit der an der Leitschichtseite eine Ansenkung (2a) aufweisenden Bohrung (2) versehene Isolierstoffteil (1), dem die Leitschicht in die Bohrung hineinreicht,
- Einschieben des Anschlußleiters (4) in die Bohrung,
- derartiges aufweiten des an der Leitschichtseite liegenden Endes des Anschlußleiters (4), daß dieses und die in die Bohrung hineinreichende Leitschicht kaltverschweißt werden,
- Aufbringen einer ausreichenden Menge einer Aktivhartlotpaste
und
- Erhitzen in Vakuum oder in einer Gasatmosphäre auf eine Temperatur oberhalb der Schmelztemperatur des Aktivhartlots bis zu dessen vollständigem Aufschmelzen sowie darauffolgendes Abkühlentassen.

7. Verfahren nach Anspruch 6, bei dem die Leitschicht aufgesputtert wird.

8. Verfahren nach Anspruch 6 oder 7, bei dem das Vakuum einen Restgasdruck von weniger als 0,01 »bar (= 1 mPa) hat.

9. Verfahren nach Anspruch 6 oder 7, bei dem die Gasatmosphäre einen Druck von höchstens 10 über (= 1 kPa) hat.

10. Verfahren nach Anspruch 6 oder 7, bei dem die Gasatmosphäre aus einem inerten Gas oder einem Reaktivgas oder aus einem Gemisch von inerten und/oder reaktiven Gasen besteht.

## Claims

1. Interface connection through a hole (2) in a high-temperature-resistant and vacuum-proof insulating part (1), particularly of ceramic, glass, or a single crystal, which interface connection consists of a metallic (4) lead inserted into the hole (2) and having a coefficient of thermal expansion less than that of the insulating part (1), wherein at least one end of the lead, if it is flush with at least one surface of the insulating part, is covered with active brazing material (5) which high-vacuum-seals it to the insulating part, or, if said end projects beyond one surface of the insulating part, is high-vacuum-sealed to the insulating part by means of ring-shaped active brazing material (5′).

2. An interface connection as claimed in claim 1 wherein, for diameters of the hole (2) less than 1 mm, the diameter of the lead (4) is approximately 2% to 15% smaller than the diameter of the hole.

3. An interface connection as claimed in claim 1 or 2 wherein the insulating part (1) has on at least one of its surfaces at least one conductive layer (14, 15) which makes contact to the lead (4).

4. An interface connection as claimed in claim 3 wherein the conductive layer (14, 15) is of tantalum and the lead is of tantalum, molybdenum, tungsten, or an iron-nickel alloy which also contains cobalt if necessary.

5. Use of an interface connection as claimed in any one of claims 1 to 4 in a pressure sensor (10) comprising a diaphragm (11) and a substrate (12) which have spaced-apart, flat inner surfaces provided with at least one conductive layer (14, 15) for forming at least one capacitor or with at least one resistive layer for forming at least one strain gage and electrically connected to the respective rear side via an interface connection which is flush with said inner surface.

6. Method of producing an interface connection throuah a hole (2) in a high-temperature-resistant and vacuum-proof insulating part (1), particularly of ceramic, glass, or a single crystal, which interface connection consists of a metallic lead (4) inserted into the hole (2) and having a coefficient of thermal expansion less than that of the insulating part (1), wherein at least one end of the lead, if it is flush with at least one surface of the insulating part, is covered with active brazing material (5) which high-vacuum-seals it to the insulating part, or, if said end projects beyond at least one surface of the insulating part, is high-vacuum-sealed to the insulating part by means of ring-shaped active brazing material (5'), with at least one conductive layer (14, 15) provided on at least one of the surfaces of the insulating part (1) and making contact to the lead (4), said method comprising the following features:
depositing the conductive layer (14, 15) on the insulating part (1) provided with the hole (2), which has a spot facing (2a) on the conductive-layer side, such that the conductive layer extends into the hole;
inserting the lead (4) into the hole;
widening that end of the lead (4) which is located on the conductive-layer side, such that said end and the conductive layer extending into the hole are cold-welded together;
depositing a sufficient amount of active brazing paste; and
heating in a vacuum or in a gas atmosphere to a temperature above the melting point of the active brazing material until the latter has completely melted, and subsequently allowing it to cool down.

7. A method as claimed in claim 6 wherein the conductive layer is deposited by sputtering.

8. A method as claimed in claim 6 or 7 wherein the vacuum has a residual-gas pressure of less than 0.01 »bar (= 1 mPa).

9. A method as claimed in claim 6 or 7 wherein the gas atmosphere has a pressure not exceeding 10 mbars (= 1 kPa).

10. A method as claimed in claim 6 or 7 wherein the gas atmosphere consists of an inert gas or a reactive gas or of a mixture of inert and/or reactive gases.

## Revendications

1. Contact de passage au travers d'un alésage (2) d'une pièce en matériau isolant (1) résistant aux hautes températures et apte au vide, notamment en céramique, en verre ou en un monocristal, ce contact de passage étant constitué par un conducteur de connexion métallique (4) inséré dans l'alésage (2), dont le coefficient de dilatation thermique est inférieur à celui de la pièce en matériau isolant (1), et dont l'une au moins des extrémités, lorsqu'elle arrive au ras d'une au moins des surfaces de la pièce de matériau isolant, est recouverte d'une brasure active de brasage fort (5), qui réalise un brasage étanche au vide poussé entre le conducteur et la pièce en matériau isolant, ou bien, lorsque l'extrémité fait saillie d'une au moins des surfaces, le conducteur est brasé de manière annulaire sur la pièce de matériau isolant, par un brasage étanche au vide poussé, au moyen d'une brasure active de brasage fort (5′).

2. Contact de passage selon la revendication 1, comportant un conducteur de connexion (4) dont le diamètre, pour des diamètres d'alésage (2) inférieurs à 1 mm, est inférieur d'environ 2% à 15% au diamètre de l'alésage.

3. Contact de passage selon la revendication 1 ou 2, comportant au moins une couche conductrice (14, 15) s'étendant sur l'une au moins des surfaces de la pièce en matériau isolant (1), et en contact avec le conducteur de connexion (4).

4. Contact de passage selon la revendication 3, dans lequel la couche conductrice (14, 15) est en tantale, et le conducteur de connexion est en tantale, molybdène, wolfram ou en un alliage fer-nickel, qui le cas échéant renferme également du cobalt.

5. Utilisation d'un contact de passage selon l'une des revendications 1 à 4, dans un capteur de pression (10) comportant une membrane (11) et un corps de base (12), qui présentent des surfaces intérieures planes, espacées l'une par rapport à l'autre, et pourvues, pour former au moins un condensateur, d'au moins une couche conductrice (14, 15), ou pour former au moins une jauge de contrainte, d'au moins une couche résistive, chacune de ces surfaces intérieures étant en contact avec la face arrière respective, au moyen d'un contact de passage arrivant au ras de cette surface intérieure.

6. Procédé de fabrication d'un contact de passage au travers d'un alésage (2) d'une pièce en matériau isolant (1) résistant aux hautes températures et apte au vide, notamment en céramique, en verre ou en un monocristal, ce contact de passage étant constitué par un conducteur de connexion métallique (4) inséré dans l'alésage (2), dont le coefficient de dilatation thermique est inférieur à celui de la pièce en matériau isolant (1), et dont l'une au moins des extrémités, lorsqu'elle arrive au ras d'une au moins des surfaces de la pièce en matériau isolant, est recouverte d'une brasure active de brasage fort (5), qui réalise un brasage étanche au vide poussé entre le conducteur et la pièce de matériau isolant, ou bien, lorsque l'extrémité fait saillie d'une au moins des surfaces, le conducteur est brasé de manière annulaire sur la pièce en matériau isolant, par un brasage étanche au vide poussé, au moyen d'une brasure active de brasage fort (5′), ce contact de passage comportant au moins une couche conductrice (14, 15) s'étendant sur l'une au moins des surfaces de la pièce en matériau isolant (1), et en contact avec le conducteur de connexion (4), le procédé présentant les caractéristiques suivantes:
- on applique la couche conductrice (14, 15) sur la pièce en matériau isolant (1) comportant l'alésage (2) qui présente un chanfrein (2a) du côté de la couche conductrice, de manière telle, que la couche conductrice pénètre dans l'alésage,
- on introduit le conducteur de connexion (4) dans l'alésage,
- on évase l'extrémité du conducteur de connexion (4), située du côté de la couche conductrice, jusqu'à obtenir le soudage à froid entre cette extrémité et la couche conductrice pénétrant dans l'alésage,
- on applique une quantité suffisante de brasure active de brasage fort en pâte, et
- on chauffe sous vide ou dans une atmosphère de gaz, à une température au-delà de la température de fusion de la brasure active de brasage fort, jusqu'à la fusion complète de celle-ci, et ensuite on laisse refroidir l'ensemble.

7. Procédé selon la revendication 6, selon lequel la couche conductrice est appliquée par crépitement.

8. Procédé selon la revendication 6 ou 7, selon lequel le vide présente une pression de gaz résiduelle de moins de 0,01 »bar (= 1 mPa).

9. Procédé selon la revendication 6 ou 7, selon lequel l'atmosphère de gaz présente une pression d'au plus 10 mbar (= 1kPa).

10. Procédé selon la revendication 6 ou 7, selon lequel l'atmosphère de gaz est formée par un gaz inerte, ou un gaz réactif, ou bien un mélange de gaz inertes et/ou réactifs.
